Europäisches Patentamt

European Patent Office

Office européen des brevets

(11) Publication number: **0 328 202**
**A2**

## EUROPEAN PATENT APPLICATION

(21) Application number: 89200251.0

(22) Date of filing: 06.02.89

(51) Int. Cl.⁴: **H01L 21/265 , C30B 23/00**

(30) Priority: 12.02.88 GB 8803295

(43) Date of publication of application:
16.08.89 Bulletin 89/33

(84) Designated Contracting States:
DE FR GB NL

(71) Applicant: PHILIPS ELECTRONIC AND
ASSOCIATED INDUSTRIES LIMITED
Philips House 188 Tottenham Court Road
London W1P 9LE(GB)

(84) GB

Applicant: N.V. Philips' Gloeilampenfabrieken
Groenewoudseweg 1
NL-5621 BA Eindhoven(NL)

(84) DE FR NL

(72) Inventor: Dobson, Peter James PHILIPS
ELECTRONICS
PATENTS AND TRADE MARKS DEPARTMENT
Centre Point
New Oxford Street London WC1A 1QJ(GB)

(74) Representative: Clark, Jane Anne et al
PHILIPS ELECTRONICS Patents and Trade
Marks Department Centre Point New Oxford
Street
London WC1A 1QJ(GB)

(54) Method of forming a quantum dot structure.

(57) A method of forming a quantum dot structure on a substrate (10) and devices incorporating such quantum dot structures are described. A suspension (11) of particles (12) of a semiconductor material for forming a quantum dot structure is formed, for example as a colloid by using the so-called arrested precipitation technique, and laser electromagnetic radiation (L) of a wavelength which interacts resonantly with particles (12a) of a given size is directed through the suspension (11) towards the substrate (10) so causing particles (12a) of the given size within the suspension (11) to be deposited onto the substrate (10).

Fig.1.

# A METHOD OF FORMING A QUANTUM DOT STRUCTURE

This invention relates to a method of forming a quantum dot structure.

Crystal growth techniques such as molecular beam epitaxy enable low dimensional structures in which quantum size effects arise to be fabricated. The layer by layer growth process of molecular beam epitaxy is particularly suited to the formation of quantum well structures, that is where an ultra-thin (of the order of the electron de Broglie wavelength) layer of a semiconductor material is sandwiched between layers of a larger bandgap semiconductor material so that the ultra-thin layer forms a quantum well with quantisation of the electron and hole wavefunctions occurring in one direction, that is in the direction of the well thickness.

Recent advances in the fabrication of low dimensional structures by molecular beam epitaxy have enabled the formation of quantum dot structures, that is arrays of particles or dots which are so small that the electron and hole wavefunctions are quantised in all three orthogonal directions. Such structures are potentially important for use as the active regions of semiconductor lasers because a lower threshold current should be required than for a comparable quantum well laser, for use in optical filters and for use in non-linear optical devices as the non-linear effects seen in quantum well structures should be enhanced in quantum dot structures.

The methods currently used for forming such quantum dot structures are not however simple. Thus, if molecular beam epitaxy is to be used, then it is necessary to pattern the layer to form the quantum dot structure by, for example, electron beam lithography or ion beam etching after growth of the layer or by selectively controlling the areas in which material is grown as described in, for example, GB-B-2144151. Other techniques used include the so-called 'arrested precipitation' colloidal technique used for example in a paper entitled 'Higher excited electronic states in clusters of ZnSe, CdSe, and ZnS: spin-orbit, vibronic, and relaxation phenomena' by N. Chestnoy et al published in the Journal of Chemical Physics 85(4) on the l5th August, 1986 at pages 2237 to 2242, enhanced interdiffusion and particle growth in glasses. The currently used techniques present problems in obtaining a uniform size of particle or quantum dot within the array and where ion beams are used, for example for ion beam etching, surface damage remains a major problem. Thus, using existing techniques, the fabrication of large area quantum dot structures is difficult.

According to the present invention, there is provided a method of forming a quantum dot structure on a substrate, which method comprises forming a suspension of particles of a semiconductor material for forming a quantum dot structure and directing laser electromagnetic radiation of a wavelength which interacts resonantly with particles of a given size through the suspension towards the substrate so causing particles of the given size within the suspension to be deposited onto the substrate.

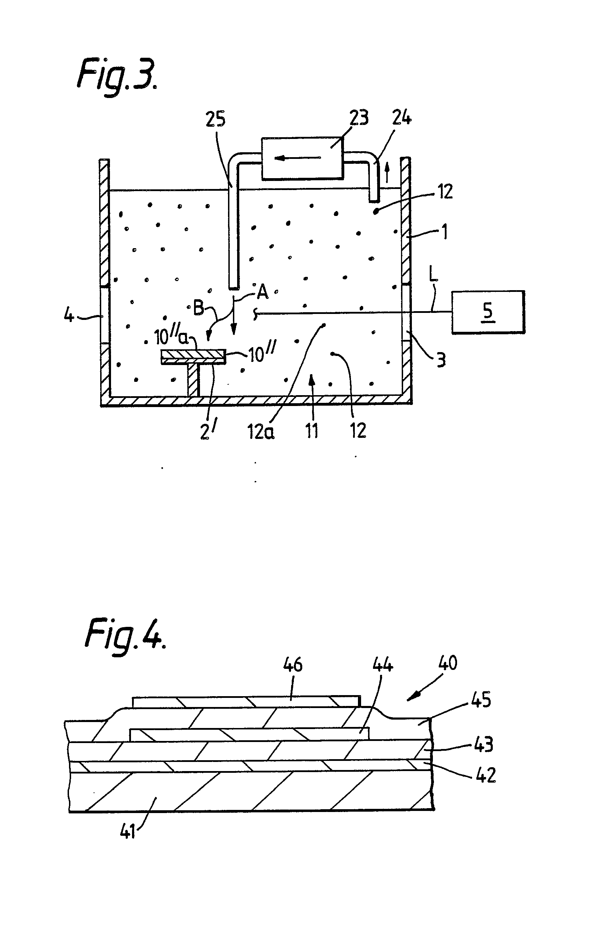

In a method embodying the invention, the electromagnetic radiation exerts a radiation pressure on the particles within the suspension. The radiation pressure exerted is greatest for those particles which interact resonantly with the electromagnetic radiation and thus by using electromagnetic radiation of the given wavelength or wavelengths the particles of the given size within the suspension interact resonantly with the electromagnetic radiation and so are caused by the radiation pressure exerted on them to be deposited on the substrate. Where the suspension is formed of particles of a semiconductor material, it will be appreciated that as described by Schmitt-Rink et al in a paper entitled 'Theory of the linear and non-linear properties of semiconductor monocrystallites' published in Physical Review B Volume 35 Number 15, l5th May 1987 -II at pages 8113 to 8125 and in a paper by C.F. Bohren published in the American Journal of Physics 51(4), April 1983 at pages 323 to 327 entitled 'How can a particle absorb more light than is incident in it?' at the exciton resonance condition for a particle the optical cross-section of the particle is much greater than the geometric cross-section of the particle because, as illustrated in Figure 3 of the aforementioned Schmitt-Rink et al paper, the local field within the particle is enhanced. The enhanced optical cross-section for such particles results in a large increase in the radiation pressure for the particles interacting resonantly with the electromagnetic radiation. Thus, particles of a given size for forming the quantum dot structure are selected in a very simple manner and by size so that the size of the dots within the quantum dot structure formed using a method embodying the invention can be deliberately selected and is not determined solely by the method used to grow the particles to form the dots. Thus, the size of dots within the quantum dot structure can be more uniform than with currently used techniques.

The electromagnetic radiation of the given wavelength is provided by a laser tuned to the desired given wavelength. The laser may be a pulsed or continuous wave laser.

The suspension may be formed by any suitable method which results in particles of a suitable size range dispersed in an appropriate medium. Thus, for example, the suspension may be formed as a colloid by a technique such as the arrested precipitation technique described in the aforementioned paper by N. Chestnoy et al published in the Journal of Chemical Physics. The suspension may be formed of particles of a semiconductor material selected from the group consisting of oxides, sulphides, selenides and phosphides of cadmium, of indium and of zinc, lead sulphide, lead selenide, silicon, selenium and gallium arsenide and other III-V semiconductor compounds. The laser electromagnetic radiation source may be of a wavelength to interact resonantly with particles of a diameter of from about 2nm to about 200nm. As used herein, the term 'diameter' should be taken to mean, in the case of non-spherical particles, an average of the dimensions of the particle. The average L of the dimensions of the particle may be taken to a reasonable approximation to be

$$ L = \left( \frac{1}{L^2_x} + \frac{1}{L^2_y} + \frac{1}{L^2_z} \right)^{-0.5} $$

where $L_x$, $L_y$ and $L_z$ are the dimensions of a right parallelopipedal box into which the particle just fits.

Alternatively, the suspension may be formed as a smoke by heating a sample of the material to form the particles to sublimation point in an inert atmosphere.

Embodiments of the invention will now be described, by way of example, with reference to the accompanying drawings, in which:

Figure 1 is a simplified schematic part cross-sectional view of apparatus for carrying out a first embodiment of a method in accordance with the invention;

Figure 2 is a simplified schematic part cross-sectional view of apparatus for carrying out a second embodiment of a method in accordance with the invention;

Figure 3 is a simplified schematic part cross-sectional view of apparatus for carrying out a third embodiment of a method in accordance with the invention;

Figure 4 is a schematic cross-sectional view of a light emitting device incorporating a quantum dot structure manufactured using a method in accordance with the invention; and

Figure 5 is a schematic perspective view of an optical switching device incorporating a quantum dot structure manufactured using a method in accordance with the invention.

Referring now to the drawings, it should first be understood that, as indicated above, the Figures are merely schematic and are not drawn to scale. Thus, various relative dimensions may have been exaggerated or reduced in the interests of clarity.

A method in accordance with the invention of forming a quantum dot structure on a substrate 10 comprises forming a suspension 11 of particles 12 of a semiconductor material for forming a quantum dot structure and directing electromagnetic radiation L of a wavelength which interacts resonantly with particles 12a of a given size through the suspension 11 towards the substrate 10 so causing particles 12a of the given size within the suspension 11 to be deposited on the substrate 10.

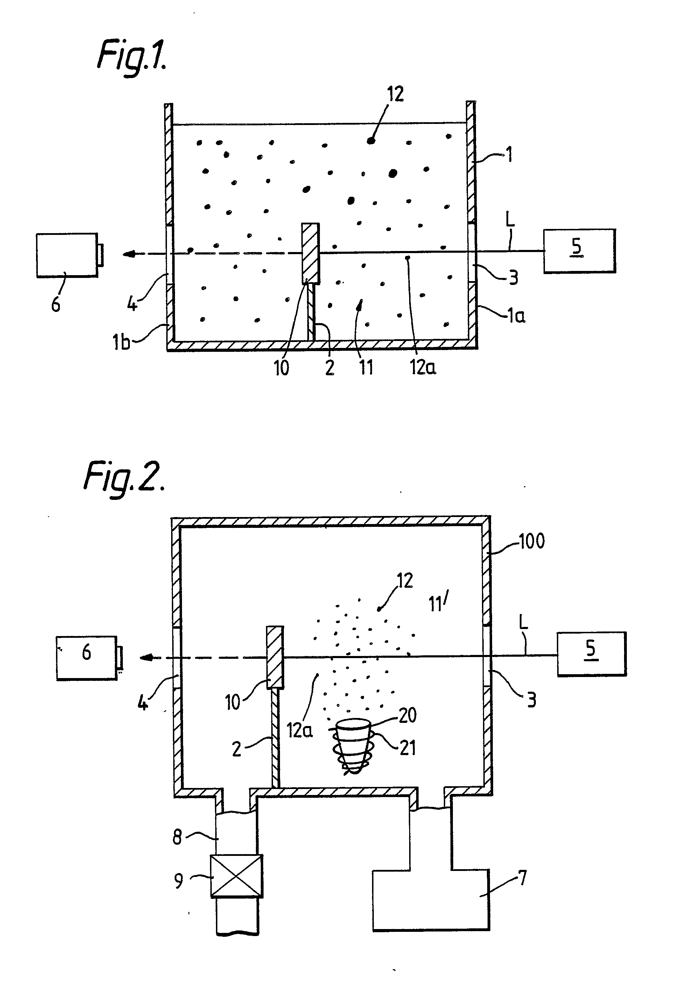

Referring now to Figure 1, there is illustrated, schematically, apparatus within which a first method in accordance with the invention is being carried out. As shown in Figure 1, the substrate 10 is mounted on a support 2 within a tank 1 so as to be aligned with windows 3 and 4 mounted in opposite side walls 1a and 1b of the tank 1. A laser electromagnetic radiation source 5, preferably a laser source, is aligned with the windows 3 and 4 so as to enable a beam L of laser electromagnetic radiation to be directed through the window 3 onto the substrate 10. Electromagnetic radiation from the electromagnetic radiation source 5 passing through the substrate 10 and the window 4 is received by a detector 6 which may be of any conventional type suitable for monitoring the intensity of the electromagnetic radiation transmitted through the substrate 10.

The suspension 11 of particles 12 is formed in the tank 1, in this example, as a colloid using the so-called technique of arrested precipitation which can be used to form colloids of semiconductor material such as silicon and sellenium and compound semiconductor materials such as oxides, sulphides, selenides and phosphides of materials such as cadmium, indium and zinc, that is CdO, CdS, CdSe, $Cd_3P_2$, $In_2O_3$, $In_2S_3$, $In_2Se_3$, InP, ZnO, ZnS, $Zn_3P_2$ and other compound materials such as lead sulphide (PbS) and lead selenide (PbSe). The particles should be passivated and, for example, the techniques described in the aforementioned paper by N. Chestnoy et al or in a paper by A.J. Nozik et al published in the Journal of Physical Chemistry 1985 volume 89 pages 397-399 entitled 'Size Quantization in Small Semiconductor Particles' may be used to form a colloid of ZnSe, CdSe, CdS or PbS by arrested precipitation.

The range of diameters of the colloidal particles produced using the arrested precipitation method will depend on the particular technique used but particles with diameters in the range of from about 2nm to about 200nm may be produced.

The substrate 10 into which particles of a selected size are to be deposited may be formed of any suitable carrier material. Thus, for example, the substrate 10 may comprise a glass slide or support member which has been coated with a tacky inert carrier material to which particles can adhere and which can subsequently be set, for example by baking to a moderate temperature, e.g. 140-150 degrees Celsius, or by ultra violet curing. Thus, the carrier material may be a plastic material, such as polymethylmethacrylate (PMMA), a polyimide or an acrylic resin, which can be spun-coated onto the glass substrate.

The electromagnetic radiation source 5 is a high powered laser source which is arranged to provide electromagnetic radiation L of a wavelength which is resonantly absorbed by particles 12a of a given size. As described in the paper entitled 'How can a particle absorb more than the light incident on it?' by C.F. Bohren published in Am. J. Phys. 51(4) April, 1983 at pages 323 to 327 and the paper entitled 'Theory of the linear and non-linear optical properties of semiconductor microcrystallites' by S. Schmitt-Rink et al published in Physical Review B Volume 35 Number 15, 15th May 1987-II at pages 8113 to 8125, such resonant absorption results, in semiconductor particles, from exciton resonance.

As described in the aforementioned papers by Bohren and Schmitt-Rink et al, when resonant absorption of electromagnetic radiation occurs, the optical or electromagnetic radiation cross-section of the resonantly absorbing particle is much greater than the geometrical cross-section. As explained in the above-mentioned papers, this is because of the local field enhancement, that is the crowding of the Poynting vector field lines, within the particles 12a which are interacting resonantly with the incident electromagnetic radiation. The increased optical cross-section for particles 12a which are interacting resonantly with the incident electromagnetic radiation means that the particles 12a experience a much greater radiation pressure than the remaining particles 12 which are not interacting resonantly with the incident electromagnetic radiation.

Thus, by selecting the wavelength of the electromagnetic radiation L from the source 5, particles 12a of a given size within the suspension 11 are caused by the enhanced radiation pressure to move towards the substrate 10 and are deposited thereon. Where the suspension 1 is a colloid of cadmium sulphide particles 12, then the electromagnetic radiation source 5 may be an Argon ion laser tuned to a wavelength of 454.5nm so that particles of a size of 65±2 Angstroms interact resonantly with the incident electromagnetic radiation and are driven by the enhanced radiation pressure onto the substrate 10.

Thus, particles of a selected size small enough to form quantum dot structures are deposited onto the substrate 10 by photophoresis. Where the substrate 10 is transparent, or at least partially so, to the incident electromagnetic radiation, the detector 6 may be used to estimate the degree of deposition of particles 12a on the substrate 10.

The laser electromagnetic radiation beam may be directed through the suspension 11 towards the substrate 10 so that the beam has a cross-section equal to or greater in area than the substrate so that all particles of the given size lying in the path of the beam interact resonantly with the beam and are moved towards the substrate 10. Alternatively, the laser electromagnetic radiation source 5 may be focused down to a spot of the order of a few micrometres in diameter and may be scanned or otherwise directed across the substrate through the suspension so that a predetermined pattern, for example an array, of quantum dot structures can be formed.

Alternatively, interfering separate electromagnetic radiation beams could be used to produce an interference pattern of electromagnetic radiation so as to deposit particles of the given size at selected positions on the surface 10a determined by the interference pattern.

Also, the electromagnetic radiation source 5 may be capable of providing, either simultaneously or sequentially, electromagnetic radiation beams of different wavelengths so that several different sizes of particles 12a may be deposited onto the substrate 10.

After a desired pattern of quantum dot structures of the given size has been deposited, then the substrate may be removed from the tank 1 and a further layer of the carrier material, for example PMMA, spun-coated onto the substrate so as to cover the deposited quantum dot structures. The structure may then be returned to the tank and the above described process repeated so as to form one or more further layers of quantum dot structures. The further layers need not necessarily be formed by particles of the same size but may be formed of particles of a different size by altering the wavelength of the laser electromagnetic radiation used to cause the particles to be deposited on the substrate.

Once the desired number of layers of quantum dot structures has been completed, a final covering or capping layer of the carrier material is applied and then the entire structure subjected to the appropriate baking or UV curing technique, depending on the material of the carrier material, so as to set the structure.

Any other suitable method of forming a suspension of passivated particles of the appropriate size, i.e. up to maximum of about 200 Angstroms diameter, may be used. Thus, for example as illustrated schematically in Figure 2, where appropriate the suspension of particles 12 may be formed as a smoke 11' by heating a bulk sample of the material to form the particles to sublimation point in an inert gas atmosphere. Such a technique is described in, for example, a paper by K. Kimoto et al published in the Japanese Journal of Applied Physics Vol 2 No. 11, November 1963 at pages 702 to 713.

As shown schematically in Figure 2, a low pressure chamber 100 is used to which the inert gas, such as argon, is supplied via a pipe 8 and a control valve 9. A vacuum pump 7 is provided to maintain a low pressure, of the order of 1mm Hg (133 Pa) inert gas atmosphere within the chamber 100. A bulk sample of the material from which the smoke is to be made is placed in a crucible 20 and heated by a tungsten wire heater 21 encircling the crucible 20 to sublimation point to provide the suspension or smoke 11' of particles 12.

If the material to be used to form the smoke has a tendency to dissociate when heated to sublimation then a technique such as that described in a paper entitled 'a new preparation method of ultra-fine particles of metal sulfides' by Kaito et al published in the Japanese Journal of Applied Physics Volume 26 No. 12 December 1987 at pages L1973-L1975 may be used in which separate sources of sulphur and the metal, for example lead, are heated together in an inert gas atmosphere at low pressure. A similar technique may be adopted where particles of a III-V semiconductor compound are required. Thus, a sample of a III-V semiconductor compound may be heated to sublimation in an inert gas, e.g. argon, atmosphere at low pressure together with a separate source of the group V element so that there is an excess of the group V element. Such a technique may be used to form a smoke of gallium arsenide particles.

As an alternative method of forming the suspension 11, a chemical reaction technique can be used in which the particles are formed by reaction between two gases as described in, for example, a paper by A. Gupta et al published in the Journal of Applied Physics 61(3) 1st February 1987 at pages 1162 to 1167 and the references described therein. Once the smoke or the type of suspension has been formed, the method proceeds as described above in relation to Figure 1.

Figure 3 illustrates a modification of the method described above with reference to Figure 1. As can be seen from Figure 3, the substrate 10" is mounted on a support 2" so that the surface 10a" is horizontal. A circulating pump 23 having an inlet pipe 24 and an outlet pipe 25 is mounted to the top of the tank to cause vertical circulation within the suspension 11 so that, as indicated by the arrow A in Figure 3, there is a resultant downward force of particles just to one side of the substrate 10. The electromagnetic radiation source 5 when activated provides a beam of electromagnetic radiation L at an angle to the downward force indicated by the arrow A so that particles 12a of the given size interacting resonantly with the beam L are deflected as indicated by the arrow B so as to be deposited onto the substrate 10. By using an electromagnetic radiation source 5 with several different wavelengths, for example a tuneable continuous wave or pulsed laser, particles of several different sizes may be separated and deposited.

The use of a method embodying the invention enables a quantum dot structure to be formed simply and easily without the need for the use of electron beam lithography or ion etching. Moreover, because most of the applications of quantum dot structures are optical, the selection of the particles to form the quantum dot structure by using the above descibed optical resonance ensures that only optically active particles of the correct size are used.

Figure 4 illustrates very schematically, and in cross-section, one example of an opto-electronic device incorporating a quantum well structure manufactured using a method in accordance with the invention.

As shown in Figure 4, the device 40 comprises a substrate 41, for example a glass substrate, onto which a transparent electrically conductive layer 42, for example a layer of indium tin oxide, is provided. The electrically conductive layer 42 is covered with a layer 43 of an insulating material, which may be a cured layer of the carrier material mentioned above, for example a layer of PMMA, polyimide or an acrylic resin. On top of the layer 43 is provided the active area 44 which is manufactured as described above and this consists of one or more layers of the carrier material into which particles of a selected semiconductor material have been embedded using one of the methods described above. A further layer 45 of the insulating material covers the active area and an electrically conductive contact layer 46, for example an aluminium contact layer is provided on top of the further layer 45. When a voltage is applied across the electrically conductive layer 42 and the electrically conductive contact layer 46, carriers are injected into the active area resulting in the emission, possibly if population inversion can be obtained in laser emission, of electromagnetic radiation of a wavelength determined by the quantised conduction and valence band energy levels of the quantum dots. Thus, a light emitting device is formed for which the wavelength of the emitted light can be selected by selecting the semiconductor material used to form the particles of the suspension and by selecting the given size of particles deposited on the substrate by selecting the wavelength of the laser electromagnetic radiation.

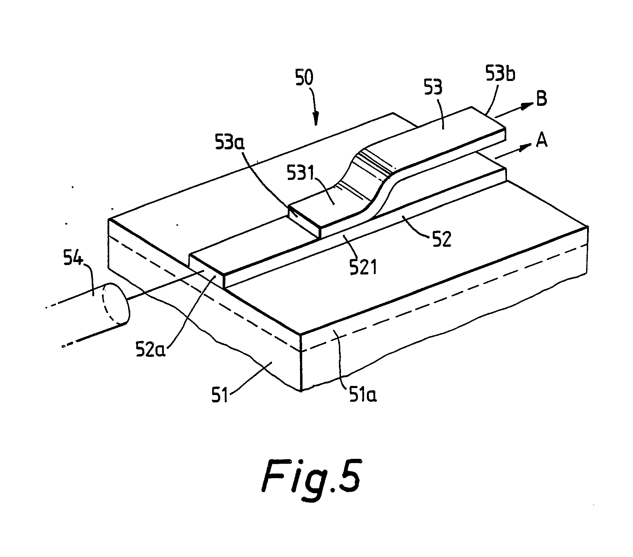

Figure 5 is a schematic perspective view of an optical switching device in which the active area is a quantum dot structure formed using a method in accordance with the invention.

As shown in Figure 5, the device 50 comprises substrate 51, for example a glass substrate. A layer of the carrier material, for example PMMA, polyimide or an acrylic resin, is spun-coated onto the substrate 51 and a quantum dot structure manufactured using one of the methods described above. Using conventional photolithographic and etching techniques the quantum dot structure is patterned to define a strip 52. Although not shown in Figure 5, a cladding layer is provided over the strip 52. A window is then opened in the cladding layer to expose the surface of an area 521 of the strip 52 and a further layer of the carrier material is then spun-coated onto the cladding layer and photolithographically patterned to define a strip 53 which contacts the strip 52 at the area 52 adjacent one end 53a of the strip 53. A final cladding layer (not shown) is provided over the strip 53. The cladding layers are selected so as to have a refractive index lower than that of the carrier material so that the strips 52 and 53 form waveguides. Where the substrate 51 is made of a light glass such as a lithium glass then the strip 52 may be formed directly onto the substrate. Alternatively a low refractive index cladding layer 51a may be provided, as indicated by the dashed line, between the substrate 51 and the strip 52. The cladding layers may be, in this example, formed of a material such as lithium glass or of, for example, collodian. Electromagnetic radiation having a wavelength just above the confined exciton resonance of the quantum dot structure, is introduced into one end 52a of the strip 52 by an optical fibre coupling 54 as is known in the art. At relatively low light intensities, the quantum dot structure containing strip 52 will have a higher refractive index than the strip 53 and accordingly the area 53 of the strip 53 in contact with the area 52 of the strip 52 will act as a waveguide cladding layer causing light travelling along the strip 52 to be output at the other end 52b of the strip 52 as indicated by the arrow A in Figure 5.

The quantum dot structure containing strip 52 acts as a non-linear medium and has a refractive index which varies with the intensity of the electromagnetic radiation travelling along the strip 52. When the intensity of the electromagnetic radiation reaches a given level, the refractive index of the strip 52 is so reduced that the electromagnetic radiation can leak out of the strip 52 into the strip 53 providing an output from the other end 53b of the of the strip 53 as indicated by the arrow B. Thus, a bistable optical switch is formed in which the intensity of the incident electromagnetic radiation determines whether an output is provided from the end 53b of the strip 53 or the end 52b of the strip 52. Various other geometries for similar bistable optical switches are, of course, possible.

Although in the arrangements described above, a quantum dot structure produced using a method in accordance with the invention may be used directly in an optical device such as a light emitting device or an optical switching device, it may be possible where the carrier material can be dissolved without affecting the particles or quantum dots to collect the particles deposited onto the substrate and then redisperse them as a suspension in an appropriate medium and then repeat the method described above with reference to Figure 1, 2 or 3 so as to provide a quantum dot structure in which the size of the particles is even more closely confined to a particular desired size. Also where the carrier medium can be manipulated, for example by extrusion, it may be possible to remove a layer of carrier material in which a quantum dot structure has been formed from any underlying substrate and then shape the carrier material, for example by extrusion, to provide, for example, optical fibres of the non-linear quantum dot containing material.

From reading the present disclosure, other modifications will be apparent to persons skilled in the semiconductor art for example persons skilled in the design, manufacture and/or use of semiconductor devices. Although claims have been formulated in this application to particular combinations of features, it should be understood that the scope of the disclosure of the present application also includes any novel feature or novel combination of features disclosed herein either explicitly or implicitly or any generalisation or modification of that feature or of one or more of those features, whether or not it relates to the same invention as presently claimed in any claim. The applicants hereby give notice that new claims to such features and/or combinations of such features may be formulated during the prosecution of the present application or of any further application derived therefrom.

## Claims

1. A method of forming a quantum dot structure on a substrate, which method comprises forming a suspension of particles of a semiconductor material for forming a quantum dot structure and directing laser electromagnetic radiation of a wavelength which interacts resonantly with particles of a given size through the suspension towards the substrate so causing particles of the given size within the suspension to be deposited onto the substrate.

2. A method according to Claim 1, which comprises forming the suspension of particles as a colloid.

3. A method according to Claim 1, which comprises forming the suspension as a smoke by heating a sample of the material to sublimation in an inert atmosphere.

4. A method according to Claim 1, 2 or 3, which comprises forming the suspension of particles of a semiconductor material selected from the group consisting of oxides, sulphides, selenides and phosphides of cadmium, of indium and of zinc, lead sulphide, lead selenide, silicon, selenium and gallium arsenide and other III-V semiconductor compounds.

5. A method according to Claim 1, 2, 3 or 4, which comprises directing laser electromagnetic radiation of a wavelength which interacts resonantly with particles of a diameter of from about 2nm to about 200nm through the suspension.

6. A method according to any one of the preceding claims, which comprises directing the electromagnetic radiation through the suspension by scanning a beam of electromagnetic radiation in a predetermined manner across the substrate through the suspension.

7. A method according to any one of the preceding claims, which comprises directing the electromagnetic radiation through the suspension by directing a spatial pattern of electromagnetic radiation through the suspension onto the substrate.

8. A method according to any one of the preceding claims, which comprises applying a force parallel to the surface of the substrate to the particles in the suspension and directing the electromagnetic radiation so as to cause particles of the given size to be deflected onto the substrate.

9. A method according to any one of the preceding claims, which comprises adjusting the wavelength of the electromagnetic radiation to alter the given size of particle deposited on the substrate.

10. A method according to any preceding claim, which comprises providing the substrate by coating a support member with a curable carrier material.

11. A method according to Claim 10, which comprises providing as the curable carrier material a plastics material such as polymethylmethacrylate, polyimide or an acrylic resin.

*Fig.1.*

*Fig.2.*

## Fig.3.

## Fig.4.

**Fig.5**